(19)

**Europäisches Patentamt**
**European Patent Office**
**Office européen des brevets**

(11)  **EP 3 121 146 A1**

(12)  **EUROPEAN PATENT APPLICATION**
published in accordance with Art. 153(4) EPC

(43) Date of publication:
   **25.01.2017 Bulletin 2017/04**

(21) Application number: **14886203.0**

(22) Date of filing: **17.03.2014**

(51) Int Cl.:
   **B82B 1/00** (2006.01)   **B82Y 30/00** (2011.01)
   **H01J 1/304** (2006.01)   **H01L 29/66** (2006.01)

(86) International application number:
   **PCT/JP2014/059380**

(87) International publication number:
   **WO 2015/141015 (24.09.2015 Gazette 2015/38)**

(84) Designated Contracting States:
   **AL AT BE BG CH CY CZ DE DK EE ES FI FR GB
   GR HR HU IE IS IT LI LT LU LV MC MK MT NL NO
   PL PT RO RS SE SI SK SM TR**
   Designated Extension States:
   **BA ME**

(71) Applicant: **Mabuchi, Mahito**
   **Kyoto-shi 600-8096 (JP)**

(72) Inventor: **ASHIDA, Yu**
   **Kyoto-shi**
   **Kyoto 601-1122 (JP)**

(74) Representative: **Herrero & Asociados, S.L.**
   **Alcalá 35**
   **28014 Madrid (ES)**

(54)   **ELEMENTARY ELEMENT**

(57)   The present invention designs an elementary element which operates by low-energy particles less susceptible to influence on an S/N ratio by the particles pseudo-one-dimensionally structuring a particle movement portion of particles including electromagnetic waves, electrons, holes, atoms, and molecules between emission and absorption sources of the particles. The present invention designs an elementary element which comprises a modification portion for allowing the particle movement portion coming and going of particles between another elementary element and the elementary element, an interaction, a chemical reaction, and the like between these particles, and time dependent mechanical/electromagnetic force, and controls the emission/absorption of low-energy particles less susceptible to the influence of atomic/molecular species of a constituent material of the particle movement portion, the stereo structure or lattice thereof, the disorders thereof, or the heat of the device thereof on the S/N ratio, and a device constructed from a plurality of elementary elements, which enables much better readiness of a catalytic action not only to control electrons and holes of a transistor and the oxidation-reduction reaction of a fuel cell but also to control the input/output of neutral or ionized atoms than conventional catalysts, tolerance to external field noise including external radiation, and a reduction in energy consumption required to operate the transistor and the like at low temperatures. A device, a module, and a system are constructed from elements including the elementary elements and others.

EP 3 121 146 A1

## Description

{Technical Field}

The present invention relates to that in an elementary element having an emission source and an absorption source of particles including electromagnetic waves, electrons, holes, atoms, molecules and the like, the elementary element comprises modification portions for allowing the particles of the elementary elements coming and going among other emission sources and other absorption sources of other elementary elements, for allowing an interaction, a chemical reaction, and the like among two or more these particles of the elementary element and the other elementary elements and for allowing time dependent mechanical/electromagnetic force, on the modification portions which face with either emission sources or absorption sources of the other elementary elements and/or in a space which is constructed from either the emission sources or the absorption sources of the other one or more elementary elements, controls the emission/absorption of low-energy particles less susceptible to the influence on an S/N ratio of atomic/molecular species of a constituent material of particle movement portions between the emission source and the absorption source, the stereo structure or lattice thereof, the disorders thereof, or the heat of the device thereof, and a device constructed from a plurality of the elementary elements, moreover, a device, a module, and a system constructed from elements including the elementary elements and others.

{Background Art}

Electromagnetic waves or particles, etc. (thereafter, if particle species are not specified, those are abbreviated referred particles) beams use to analyze the physical and chemical structure of a sample by irradiating these beams, to perform a physical or chemical process by exposing to and/or irradiating a substance or as an energy source.

To analyze structures of materials, an electron beam is used in a scanning electron microscope, a transmission electron microscope, an electron beam lithography exposure, a thermionic emission electron gun, a field emission electron gun or the like. In the field emission electron gun, an electron emission area can be reduced in heating a radius $0.4\mu m$ of the cathode tip sphere to 1800K, what is more, an electric field applied to the electron emission area is $\sim 10^8$ V/m, the electron beam is three orders of magnitude higher brightness compared to the thermionic emission electron gun. Moreover in the field emission (Schottky) electron gun cathode as well as the thermionic emission type, Schottky shield, a first and a second anodes have to be heated. And using a pierce type electron gun structure having a self-focusing characteristic electron stream of concave shaped cathode, a thermal electron stream of the concave shaped cathode is focused as a laminar flow. The thermal electrons emitted from heated cathode of the pierce type electron gun, by applying an acceleration voltage between the concave shaped cathode and an anode, are drawn from a hole of the anode, but like as a thermionic cathode electron gun, the concave shaped cathode has to be heated. (NPL1, NPL 2)

According to NPL 3, in the field emission (Schottky) electron gun using single walled or multi walled carbon nanotubes, a distance from the anode terminal to the cathode surface which is a tip of the single walled carbon nanotube at $1.6\mu m$ height from a cathode terminal and of 7.5nm radius is $2.13\mu m$, and applying voltage $\sim 30V$ between the anode terminal and the tip of single walled carbon nanotube makes a current up to $\sim 10^{-7}$ A per single walled carbon nanotube.

And particle beams have been utilized to perform the physical or the chemical processes, examples of those beams are in a molecular beam epitaxy, an ion beam lithography, an ion implantation and so on. For a focused ion beam, it is possible to process target materials in nano-order. The particle beams are also used to excite gases, control a discharge or use a plasma ignition.

Atomic/molecular particle beams are named as ion beams or radical beams according to way of charging. In the character of some beams, electromagnetic waves such as light waves and the like can be thinkable. As such beams polarization beams exist. Positrons can be in particle beams. It is conjecture in PTL 1 that the positrons are generated from ikosolids composed from plurality of trisoctahedrons.

As lower a temperature of conductor is, scattering of conduction electrons due to lattice vibrations or the conduction electron-conduction electron interactions is negligibly low. And a residual resistivity of the conduction electrons dominated by impurity scattering is usually remained. And an electric resistivity of perfect crystals having no impurity also varies greatly due to constituent atoms and crystal structures.

In random potential fields, if a size of two or less spacial dimensional conductors is large, its electric conductivity becomes zero according to Anderson localization (NPL 4).

Pseudo-one-dimensional systems having a narrow cross-section area perpendicular to a conduction direction described below are in a three-dimensional system, therefore no Anderson localization occurs.

Increasing an impurity concentration $c$ in the three-dimensional system and closing a temperature of the system to absolute zero, wave-functions of the conduction electrons in the three-dimensional systems are usually localized, so the wave-function $\Psi$ can be approximated with $\exp(-r/\xi(c))$. Here $r$ is a position variable of the wave-function, and $\xi(c)$ is an attenuation coefficient at $c$. The conduction electrons moving along a system size $L$ conduct electrically without local-

ization when L is smaller then$\xi$(c).

In case that, at the absolute zero temperature $T = 0$, a density of state of the conduction electrons in the three-dimensional conductor is assumed to be that of free electrons, a correlation wave-function, which is represented by off-diagonal r' = 0and$r > 0$positions for two different wave-functions of the free electron times the density of state for the free electron multiplied by Fermi distribution function at T = 0, is that of a spherical wave for the free electron which decays as inverse square of a sphere radius$r$, but the spherical wave-function of free electron is not disturbed by the temperature. Here$r$is the position variable for one of the two wave-functions. But ways of attenuation manner for the correlation wave-function are more greatly varied by the density of state for the conductor which depends on atomic species making up the conductor. A wave-function$\Psi_{pse}$of the conduction electron in the pseudo-one-dimensional system similarly attenuates as the ways of attenuation manner for the correlation wave-function. $\Psi_{pse}$depends on the density of states of the conduction electrons for the conductor in the pseudo-one-dimensional system, however, when cis large, $\Psi_{pse}$also decays as$\exp(-x/\xi_{pse}$ (c)). Here$x$is a variable along a conducting direction of the conduction electron. The correlation wave-function$\Psi$of the conduction electron in the pseudo-one-dimensional system is attenuated in same way as$\Psi_{pse}$.

When the temperature of the pseudo-one-dimensional system is increased, the electric resistivity of the conductor is subjected to scattering of the electron-electron interactions that depend on the lattice vibrations and differences in the constituent atoms, so that the decay of amplitude for the correlation wave-function of the conduction electron occurs. Therefor $\xi(c)$is a function $\xi(c,T)$ of the temperature$T$(NPL 5). As a result, values of the electrical resistivity for the conduction electron vary greatly in magnitude relation among $\xi(c,\ T)$ , Land an elastic scattering length $l_e$of the conduction electron. But considering about $\xi(c,T)$, in which the elastic scattering among the conduction electrons has been considered in the density of state used in numerical calculation for the correlation wave-function of the conduction electron, following cases can be considered.

{Math. 1}

$$1. L \gg \xi(c,T),$$

in such case, a current of the conduction electron attenuates perfectly and dose not occur.

{Math. 2}

$$2. \xi(c,T) \geq L,$$

in such case, the conduction electron is scattered with the lattice vibrations, the impurities and other conduction electrons, the conduction electron including the other conduction electrons flows as a diffusive conduction.

{Math. 3}

$$3. \xi(c,T) \gg L,$$

in such case, the conduction electron is not scattered with the lattice vibrations, the impurities and the other conduction electrons, the conduction electron flows as a ballistic conduction.

It is, moreover, necessary to consider a similar comparison between$L$and $\xi_i^s(c),$ which is derived from an$l$ - $th$correlation wave-functions of the conduction-electron in the conductor including self correlation wave-functions. Here$s$is used for a distinction between self and not-self, $l$is 2 or more integer(NPL 5).

As described above, attenuations of the conduction electron depend on the atomic species and stereo structures constituting the conductor except the particle beams and on the temperature of the conductor, and on the impurity concentration of the conductor, therefore, in the above mentioned system, the attenuation coefficient of the wave-function of the particle beams in the conductors depending$c$is determined.

Electromagnetic waves, neutral/charged atoms or electron beams emitted from a beam emission/absorption element (hereafter, an element is used in order to specify differences from the elementary element of the present invention) are in a bad S/N ratio of the particle beams, because flows of the particle beams are disturbed by lattice vibrations due to the heat in the particle beam emission/absorption element. In addition, through disturbances due to Coulomb and correlation interactions between charged/neutral particles in the particle beams, due to impurities in the particle beam emission/absorption element, and due to external fields and other particle flows around in the particle beam emission/absorption element the S/N ratio becomes worse, but flow rates of the particle beams are determined by depending on the atomic species constituting the particle beam emission/absorption element. Through the lattice vibrations in the particle beam emission/absorption element or the disturbances due to the impurities and disorders of the atomic/molecular configurational structures in the particle beam emission/absorption element, each energy state of the particle in the particle beams has a width, which is calculated in the quantum mechanics. A thermal noise of the particle beam emission/absorption element causes a transition between energy levels of each particle in the particle beams. An influence of the S/N ratio owing to the heat of the particle beam emission/absorption element is determined by the temperature of the particle beams emission/absorption element and is small at low temperature.

A negative Electron Affinity(NEA) device, whose interface easily emits electrons as low-kinetic-energy particles, is found. It can be used as NEA photoelectric surface, secondary electron surfaces, cold cathodes and so on. According to NPL 6, it is possible to decrease the emission area size of NEA cold cathode to an extreamely small one, moreover, to place many NEA cold cathodes adjacent each other and to control emitting electron flows by bias currents, for the sake of this flow control, the NEA cold cathode can control the electron beam quickly and an energy consumption of the NEA cold cathode is much less than that of the thermoionic cathode electron gun having parts applying an acceleration voltage between the cathode and the anode to thermoelectrons emitted from the heat cathode. Because of stable the NEA surfaces being required, an emission efficiency and a life-time of NEA device becomes many problems awaiting solution.

Although a photoelectric surface dose not respond to a long wavelength limit, the NEA device has no longer the long wavelength limit. In the case of the heated cathode a negative voltage control electrode, an accelerating electrode and a beam limiting aperture, which are not required in the NEA device, are necessary. The NEA device, however, needs the stable NEA surface, so that the NEA device rises problems about the efficiency and the life-time of it. High brightness and low emitance photo cathode for a spin-polarized electron source, in which the NEA surface is required, has the above mentioned problems. On the other hand, a photo cathode for spin-polarized electron source using GaAs crystal of PEA (Positive Electron Affinity) surface of pyramid, that dose not require the NEA surface, is found. The GaAs crystal of the PEA surface of the pyramid is irradiated by a circularly polarized laser, particular spin electrons are excited selectively from a valence band into a conduction band. While the particular spin electron group are disturbed by thermal noise in the GaAs crystal before being emitted from the PEA surface, a quantum efficiency and a spin polarization of the particular spin electron are enhanced by the tunnel (NPL 7).

A thermoelectric conversion that utilizes each working substance having a polarity of charged particle in its own conductor both carring its own thermal energy and changing an electromotive force difference in its own conductor and is an element by converting the thermal energy into an electrical energy and vice verse. It is possible for the element to generate the electrical energy from a waste heat, or to heat or to cool materials by applying an electric current to the element. Thermoelectric conversion element, which improves a figure of merit of the thermoelectric conversion, utilizes the electromotive force due to thermoelectric materials in the thermoelectric conversion element and is aimed to control a thermal noise distribution occurring only in velocity distributions of the working substance moving in the psedo-one-dimensional motion through the psedo-one-dimensional parts(PTL 2, PTL 3). The sources of the working substance are conductors and semiconductors in an electric circuit.

An environmental and energy technology represented in a fuel cell and a purification for automobile exhaust gas, where the source of particles being not a conductor is taken as an example, are essential to the human society in the 21st century, in order to achieve both an energy supply and an environmental conservation. An electrolyte used in the fuel cells is classified into five such as an alkaline type, a solid polymer type, a phosphoric acid type, a molten carbonate type and solid oxide type fuel cells, and features and drawbacks in each electrolyte are different. It is having been atracting that with multifunctional advances of portable small electronic devices a power source of the portable small electronic devices is going to replace a lithium battery with micro polymer electrolyte fuel cell (PEFC) of about several tens Ws.

In direct methanol fuel cells (DMFC) making use of a very high net energy density of methanol, on a membrane electrode assembly(MEA) in contact with a methanol aqueous using the methanol aqueous and an oxygen gas, a methanol oxidation rate is slow evenwhen a large amount of precious metal anode catalyst is used. And a reduction of the life for an alkaline electrolyte because productions at $CO_2$ emission in the anode contact with the alkaline electrolytes using solutions of potassium hydroxide and the like, those of a resistance overvoltage, a concentration overvoltage and an activation overvoltage and so on due to poisoning or a penetration reduction of the methanol into the alkaline electrolyte and the like are required.

Both PEFC, which operates from the room temperature to 100°C, and a methanol fuel cell (MFC) have MEA that is a constructed polymer electrolyte membrane (PEM) sandwiched in two electrodes made from a porous support layer + anode catalyst layer and a porous support layer + cathode catalyst layer. Of sandwiching the MEA in the separator a fuel cell unit is composed. In PEM of PEFC operating with a hydrogen gas and oxygen in air at the MEA, it is necessary to be humidified in order to maintain a proton conductivity of the polymer electrolytes, an improvement of the PEM operating in no or low humidification, that of isolation properties of the hydrogen gas crossing over PEM and management of produced water in MEA contacting with the air, however, have been required.

Thus, for the catalyst layer being one of the most important factor materials in MEA, higher catalytic activities for a reaction of interest, higher electrical conductivity, lower corrosion, and less poisoning are required.

Since it has been shown that metal nanoclusters having a diameter up to several nanometers activate oxidation reactions using oxygen, catalyst of the oxidation reactions, in which the oxygen is an oxidizer, is vigorously developed. It is found that an active point being 10nm or less diameter of precious metal nano-particles becomes "metal catalyst". Oxidizers such as metal oxides, which have been conventionally used, are generally highly toxic, so more untoxic oxidizer has been required. In the oxidation reaction using an oxygen gas as the oxidizer, a by-product is water only, so the cleaner reaction can be realized. Moreover, the catalyst of the oxidation reaction of alcohol with the oxygen gas, in which gold catalyst is immobilized to or included in polymers, is not only easy to handle at high activity, but also has advantages such as recovery, re-used and the like. That makes the advantages of the catalyst be in green (environmentally friendly) ones. Further, by taking advantage of the property that a variety of metals by mixing two kinds of metals obtain new characteristics, a bimetallic nanocluster catalyst composed of gold and platinum is immobilized to a polymer, so more highly activity catalysts are synthesized. In a combination of gold and platinum and that of gold and palladium, even when a same alcohol is used as a raw material, in the former an aldehyde, and in the latter an ester are obtained selectively (NPL 8).

Hence the metal nanocluster and the anode and the cathode catalyst layers used in a fuel cell have been mainly described, Hidehiro Sakurai associated professor of Moleculare Science Institute reports that the metal nanoclusters may have typically three kinds of following characteristics, exactly:

1. Reactivity changes due to changes in a shape and an area of a metal surface:

In a cluster state, electric states due to the quantum size effect vary greatly with depending on the size and the shape of the cluster, chemical and physical properties are also adjusted to the size and the shape.

2. Metal clusters as efficient supply sources of catalytical active species:

Especially for a series of palladium cluster catalyst described as a cross-coupling reaction, the metal clusters supply constantly the active species to the reaction system in many cases. Because the active species recombine to the metal clusters again after the end of a catalytic cycle, they often act as such things as mediators to prevent a formation of an inert bulk metal. It is believed that the catalytical active species are not the cluster itself but a bare mono atomic state or atomic states of several atoms generated by being scratched from the cluster (leaching). In Heck reaction using a complex catalyst, moreover, it has been reported that the true active species are not palladium complexes themselves, but decomposing and generating clusters in the reaction system.

3. Cluster own activity by the quantum size effect:

For example, as the characteristics of gold clusters a surface plasmon resonance becomes known, it is expected that the cluster size is made small and is in the cluster size diameter of 2nm or less, so that the surface plasmon resonance is not observed and that properties of not a metal but those of a molecule are observed. In aqueous solution at the room temperature, air oxidation activity of the gold clusters in homogeneous condition having the particle diameter of less than 2nm dramatically increase. That is a comparable difference from the gold in bulk having almost no catalytic activity.

On the other hand, oxide ionic electrolytes used in typical solid oxide fuel cells (SOFC) are often in a fluorite structure. $CeO_2$, $ThO_2$, $CaF_2$, $ZrO_2$, $HfO_2$ and the like take the fluorite structure from room temperature to their melting points. Alkaline earth oxides such as CaO and the like or rare earth oxides such as $Y_2O_2$ and the like, that are guests in the solid oxide hosts, maintain solid solutions in wide ranges of guest concentration. Even if various types of lattice defects occur in basic fluorite type structures, it is known that the basic fluorite structures probable maintains each original structure (NPL 9).

Under the assumption that even if some ions of the host in the oxide ionic electrolytes being in the fluorite structure are replaced with the guests, the oxide ionic electrolytes maintain the fluorite structure, a first approximation Helmholtz free energy from which concentrations of vacancies in the oxide ionic electrolytes concerned with oxygen ion conductions are obtained, dependence of the nearest neighbor interactions among constituting atoms and by using the first approximation Helmholtz free energy the various concentrations of the oxygen vacancies are numerically calculated (NPL 10, NPL 11).

Unlike the conduction mechanism of conventional oxide ion conductors, as an electrolyte material for SOFC the oxygen ion conductor is expected to operate in an intermediate temperature range between 400 and 600°C. Oxygen ions in 2a sites arranged in the c-axis direction of an apatite lanthanum silicon oxide being the oxigen ion conductors contribute to an oxygen ion conduction. From electrical transport properties at high temperatures and a defect chemical model, an equilibrium of opposite Frenkel defects which affect the ion conduction properties is investigated. The apatite type lanthanum silicon oxide is found to be an ideal solid electrolyte. Partially replacing lanthanum with neodymium in the apatite type lanthanum oxide, moreover, an electronic conduction appears, that is not founded to be understand only by the classic defects equilibrium theory (NPL 12). And in non-experience method of band calculation of a single crystal of $Nd_{9.20}(SiO_4)_6$ replacing lantern with neodymium by using WIEN2k, whose method is (L)APW+lo extend linear expansion plane wave method to localized orbitals, it is confirmed that very small electronic conductions occur.

Unlike the fuel cell, batteries and accumulators are as examples of a storing energy. In the batteries of the former two electrodes, in which the several electrolytes are put, are furnished with circuits of external loads and with those to cause oxidation and reduction.

On the other hand, the diamond has so large band gap(5.5eV) that it becomes in a negative electron affinity (NEA) state where the bottom of its conduction band can be easy to exceed the vacuum level. In cause that electrons excited in the conduction band can freely pop into a vacuum, an electron emission state can be apt to occur. Hydrogen termination on the diamond surface makes the conduction electrons become in NEA, and oxygen termination makes the conduction electrons in the positive electron affinity (PEA).

As examples of the particle beams applying Math. 1 to 3 to the three-dimensional system; - the devices, which control electrons and holes by using the electric fields, are existing many such as a field effect transistor, a transistor, a diode, a condenser, and the like. The device that controls the spin polarization by using magnetic field is in PTL 4. In this patent litterateur, the spin polarization in materials jointing a ferromagnetic layer and a ferroelectric layer together to lattice mismatch ratio of 5% or less can be varied by applying a voltage to the materials.

A particle beam except the particle beams which are determined by Math. 1 to 3 described above do exist in the elements. Physical properties of the elements are greatly changed by species of atoms and/or molecules included in the element. In forming parts for the particle beams, which are surrounded by their respective outer wall of the element in order to block external disturbances, volumes of the forming parts for the particle beams may change. The movement portions where particles of the particle beams move are made of,

A. In metals, inter-metallic or quasi-crystalline alloys, semiconductors, ionic materials including fast ion conductors, metallic or oxide glasses, and parts made of nanoscale materials, the particles of the particle beams are in

A-1 diffusive movements,
A-2 liquid or gaseous movements.

B. Motions of the particles of the particle beams in the element in which the particles of the particle beams are only contained in the movement portions are in

B-1 Newtonian movements.

Taking account of considering each volume change_of the composition portions in A-1 described above, its respective concentration change of atoms and molecules contained therein, change of temperature and the like, an investigation for the particle beam flow in the system is analyzed by using (Math. 4) described below (NPL. 13).

In a transport equation of irreversible process for neutral and/or charged atoms, heat and electrons, the following equation between phenomenological responses for all the fluxes $J_i$ of an i specie for the neutral or the charged atoms, the heat, the electrons and so on, and its generalized thermodynamical force $x_j$ is assumed as

$$\{\text{Math. 4}\}$$

$$J_i = \sum_{j=1}^{m} L_{ij} x_j.$$

is assumed. Here $L_{ij}$ is a phenomenological coefficient or a transport coefficient which is a function of a temperature, a pressure and so on, but independent of the generalized thermodynamical force.

A gradient of an applied temperature causes the generalized thermodynamical force associated with a heat flow, or again a gradient of chemical potential does a generalized thermodynamical diffusion force; the heat flow which is diffusion responses corresponding to the former is the thermal conductivity, the latter is diffusion coefficients of the material flows. That is, parts of the matrix L which consist of $L_{ij}$ are composed of diagonally which link respective each generalized thermodynamical force with its conjugate flux. Off-diagonal coefficients $L_{ij}$ determine effects of the generalized thermodynamical force on a nonconjugated flux (examples: electromigrations, the thermoelectric material).

Features of the irreversible process are in an entropy production. With the aid of an entropy production rate $\sigma$, a heat generation rate of energy dissipation is represented as

{Math. 5}

$$T\sigma = \sum_{i=1}^{n} \quad J_i x_i + J_q x_q$$

Here, $J_i$ and $j_q$ are the $i$ specie flux and the heat flux, respectively. $x_i$ and $x_q$ are the respective displacement associated the $i$ specie and the generalized thermodynamical forces to the $i$ specie displacement and the heat $q$. And they have the following relations, respectively

{Math. 6}

$$x_i = F_i - T\nabla \frac{\mu_i}{T} = F_i - \nabla\mu_i,$$

and

{Math. 7}

$$x_q = -\frac{1}{T}\nabla T.$$

In addition, each of the $i$ specie charged or neutral charged atoms and/or molecules receives the force $F_i$ due to its respective amount of electric charge $q_i$ in electromagnetic fields and the force generated by concentration gradients.

Elastic deformations and the flows in the above A-1 and A-2 have been studied in Rheology, and fluids containing turbulent flows in the above A-2 have been studied in fluid mechanics of liquid or gas. For example,

- in beam flows composed from the electric charged or neutral charged atoms and electrons in gaseous and/or liquid state, a gas theory and a hydrodynamics including turbulent states are applied to the beam flows.

     Examples in the above B-1 are

- neutral charged particle beams, which after charged particles are accelerated are generated by a charge exchange between the charged particle and neutral charged gaseous molecules. In a device manufacture of nanoscale, defects are generated by a charge accumulation and vacuum ultraviolet lights and so on. In addition, ion sheaths decelerates velocities of the charged particles or bent their orbitals. The neutral charged particle beams are hard both to occur the charge accumulation and to generate radiation damages, and have been used to minutely construct the device. Therefore the neutral charged particle beams are obtained after the charge exchange between the charged particles and the neutral charged particles.

In PTL 5, after positive ion particles being in a monochromatic kinetic energy and a mono direction motion, the neutral charged particle beams are tried to have been made from the positive ion particles efficiently combined with electrons in eliminating most of a relative speed between the positive ion particles and the electrons. Here, it is exhibited that both a charge exchange and an elastic scattering cross-sections between the positive ion particle and the electron depend on the value of the positive ion particle energy, it have been used that the relative lower speed makes the probability of the charge exchange reaction or a combination reaction higher. In NPL 14, by using the fact that less energy is needed to neutralization of negative ion particles, the charge exchange between the negative ion particles and the neutral charged gaseous molecules creates the neutral particle beams. - Moreover, particles in the particle beams of low-kinetic-energy are scattered by target atoms, molecules and the like and affect only marked surfaces of the target sample. Using these they are utilized to examine a state of the marked surface, but it has been used that the particles in the particle beams examining the state of the marked surface have a different kinetic energy which is said to be the low-kinetic-energy, for example, the kinetic energy in ISS is less than a few keV, in this case the particle beam direction is close parallel to the marked surface of the target sample, in IEED is about 100rev, in the plasma is about 50eV, and in the cold neutron is about 5meV.

{Citation List}

{Patent Literature}

{PTL 1} Patent 2011-58856
{PTL 2} Patent 2011-57202
{PTL 3} PCT-JP2012-071529
PTL 4} Patent 2012-104768
{PTL 5} Patent H5-190296

{Non Patent Literature}

(NPL 1} Akira Honma, Akiko Sawamura, Hatsuo Yamazaki, Katsuhide Nakata, Koumei Tanida, Sadafumi Sawamura, Kunihiko Tsumori, Design of linear accelerator for low emittance electron gun, Hokkaido University Faculty Engineering Department Research Report No. 173 (1995) pp. 57-63

{NPL 2} Yoshiaki Makino, Ryo Iiyoshi, Electric field analysis of Schottky cathode by surface charge method, Aichi industrial University research report No. 41B (2006) pp33-40.

{NPL 3} B. Jean-Marc, et al., Phys. Rev. Lett. Vol.89(2002) pp.17962-1 - 19769-4.

{NPL 4} P.W.Anderson, Phys. Rev. Vol. 109(1958) 1492

{NPL 5} Mabuchi, et al. Niihama National College of Technology Bulletin Vol.35 (2002) pp.29-40

(NPL 6} Journal of Television, Vol. 32(1978) No.8 p.670

(NPL 7} M. Kuwahara,et al., development of high brightness spin polarized electron source, Japan accelerator Society Annual Meeting 2nd, (2005) p.105

{NPL 8} S. Kobayashi, et al., Remarkable Effect of Bimetallic Nanocluster Catalysts for Aerobic Oxidation of Alcohols: Combining Metals Change the Activities and the Reaction Pathways to Aldehydes / Carboxylic Acids or Esters', Journal of the American Chemical Society, 134 (2012) 16963.

{NPL 9} T. Kudo and H. Obayashi, J. Electrochem. Soc. 123 (1976) 415.

(NPL 10} Mahito Mabuchi, Daisuke Higashiura, Kenji Morita, Jun Manabe, Katsuhito Okada, Niihama National college of Technology, Vol. 42, (2006) pp.17-23.

(NPL 11} Kouji Onishi, Hiromasa Morita, Daisuke Higashiura, Mahito Mabuchi, Niihama National College of Technology Vol. 42. (2006) pp.25-34.

(NPL 12} Kiyoshi Kobayashi, Elucidation of reverse Frenkel defect equilibrium in apatite type lanthanum silicon oxide, Scientific Research Grant Program Research Report Jun 22, 2012.

(NPL 13} H. Mailer, Tatsuichiro Fujiwara, Diffusion in Solid, Maruzen publish, 2007.

{NPL 14} J. Plasma Fusion Res. Vol. 85, No. 4(2009) 199

{Summary of Invention}

{Technical Problem}

The particle beams are used to examine physical properties of a sample which is exposed to and/or irradiated by them, or to modify physicochemical properties and/or shapes of a material with the same way. Devices in which parts adjusting a flow amount of an emitted particle are included and in which parts controlling the flow of particles near an absorption part are included as in a tunneling microscope, a transistor in which an input/output of the particle beams are controlled by equipping an emission source end another absorption source end and a part to control of the particle beam flow, and photoelectric devices having emission source ends secondary particles by absorbing incident particles and/or absorption source ends of emitting secondary particles exist. The common part of those operations in the devices, the transistor and the photoelectric devices are an element used in many areas.

By being in better S/N ratio of the particle beams which have passed through elements, it is possible to determine even more detail the physicochemical properties of objects which are exposed to and/or irradiated by the particle beams or those of the source emitting the particle beams. Moreover, irradiation damages of sample exposed to and/or irradiated by the particle beams can be reduced, and energy required in order to manufacture high quality materials in cryogenic temperature can be also more reduced.

Through the elements, moreover, transistors controlling the input/output control due to having input/output controls of diffusion flows for electrons and holes between absorption source and emission source ends and fuel cells doing hydrogen, oxygen and the like ions which are controlled by, needless to say, catalytic actions doing neutral charged or ionized atoms and molecules are in much more rapid responsiveness and durability for external noise including external radiant rays than the conventional catalytic action and the like. And it is also possible to much more reduce energy required to control than the conventional transistor or the like in being at low temperatures.

The present invention, without causing poor S/N ratio by complex controls and overheating of the cathode portions such as a thermal electron beam generator, makes errs lower due to a particle number distribution caused in a process of a low-energy-particle emission or absorption end and/or errs in the cause of angular directional and kinetic energy distributions for particle beams, due to the constituent atoms and/or molecules of the elements and due to their heat alternatively, makes the elements (hereafter, as in the Technical Field, the elements are represented by the elementary element), controlling emission and absorption of low-energy particles much suppress an influence to S/N ratio such as high quantum efficiency and the spin polarization. By use of devices, modules made of plural the elementary elements and systems composed of the devices, the modules, and/or an elementary element module composed of the elementary element constructions are intended economically to be created.

{Solution to Problem}

Conventional particle beams require a heat source in order to create the particle beams, and do not reduce their thermal energies in a movement portion to the emission source end. Owing to large values of area for the emitting and the absorption source ends of the particle beams, the S/N ratio of the particle beams become worse by worse S/N ratio due to controls of the particle beams and like.

The emission source or the absorption source of electrons or holes flowing in electronic devices made of a transistors and the like are made of a conductor or a semiconductor or the like, those of a working substance flowing in a thermoelectric conversion element do conductors, semiconductors, a macroscopic quantum system or the like, or those of reaction and/or generation species of metal nanocluster and so on are the metal nanoclusters and the like, for instance. So many types of emission source or absorption source of particles are in so many different.

In a particle movement portion in which Particles of Particle Beams flow, flows of Particle Beams splinting, mixed with other Particle Beams, modified by a shape processing and/or changed by a chemical reaction are protected by an outer wall of the particle movement portion from external materials, form poisoning such as reaction and generation species and the like and external disturbances. The above reformations of the splinting, the mixing, the shape processing and/or the chemical reaction could be protected by the outer wall deforming with time. Collections of atoms and/or molecules and the like in which flows of Particle Beams develop are defined as assembly.

In case that structural phase transitions and/or dislocations and so on., large changes such as compositions, structures, placements and the like do not occur in the assembly, allowed energy states of Particles of Particle Beams for the assembly in the outer wall of a certain shape are determined by the quantum mechanics.

Particles of Particle Beams are distributed in the allowed energy states, if energy intervals of the allowed energy states are wider, it is difficult for Particles to change between the states(See Math. 1 to Math. 3). In addition, a high speed diffusion path of a grain boundary, a columnar layered porous structure, a lamellar structure and the like or the outer wall formed such as a polymer electrolyte membrane(PEM) or cell membranes make movements of Particle Beams limit to one direction.

Particle Beams in the outer wall of the elementary element as described above are in the geometric shape characterized by the length $L$ parallel to a flow direction of Particle Beams and the cross-section area $S$ perpendicular to the flow direction. In the outer wall

- structural materials of emission sources or absorption sources corresponding to respective Particle Beam are equipped with.
  Since Particle Beams may be made of neutral charged atoms and/or molecules, on the outer wall
- parts to allow modifications of Particle Beams by Particle Beams splitting for and/or mixing with other Particle Beams, and/or by their shape processing and/or by chemical reactions with other Particle Beams and structural materials in connection with the parts are equipped with.
- structural materials changing the shape of the outer wall are also equipped with, owing to alter $S$ of the assembly with time.
- low-energy particle with better improvement to the S/N ratio are manufactured, moreover $L$ of the assembly is the length to include the modification as mentioned above. Incidentally, the above the parts are zero or more. From here, they are referred it as the modification portion for simplicity.

In the "Background Art", field effect transistors, transistors and the like in electrical components are described as examples of the modification of Particle Beams on the route, however, one or more embodiments are illustrated as the examples of Particle Beams in the modification portion in accordance with the principles of the present invention, and are intended to illustrate the embodiments schematically together with the specification. Although these conceptional examples are described with an emphasis upon the nature of the invention, of course they are not intended to identify the invention.

Near-by reaction fields at the emission source and/or the absorption source and/or at the modification portions of each assembly, if necessary

- conductive coatings of surfaces for the emission source and/or the absorption source end and/or for the modification portions in contact with the reaction fields, or Particle and Particle Beams shielding structural materials which are controlled by actuators

- the actuators for fine adjustment of adjusting plates which mechanically control of reactive and productive species existed in the reaction fields near-by surfaces of the emission source or the absorption sources and/or of the modification portions,

- near-by each reaction field, static electric and/or magnetic fields and/or dynamically electromagnetic field sources which control the reactive and the productive species and those of flows,

- heating parts on the outer wall in order to eliminate contaminations on the emission sources and the absorption sources or the modification portions with oxidation, poisoning, and so on,

- removal parts in order to eliminate unnecessary generated and/or unreacted species from the reaction fields and

- plenty of the productive species in various kinds of catalytic reaction or oxidation-reduction reactions at catalyst layers in fuel cells are generated. The elementary elements corresponding to respective productive and raw species in order to make productive them into zero or more Particle Beams,

are equipped with.

A plurality of the elementary elements, in some which the above described respective zero or more of Particle Beams reach its emission source and/or are emitted from the emission sources to its each respective aimed reactive fields as its aimed reactive species in its respective minimum distances and moreover in an optimal spatial arrangement of the other elementary elements where the productive and the raw species getting away from each aimed reactive fields do not interact each other, and in all of which the above described respective zero or more of Particle Beams and the productive and the raw species getting away beams flow in its each respective elementary element with $S$ and $L$ making the S/N ratio of its Particle Beam optimize, are defined as a device,
In the device

- in order for many number of the elementary elements to be got together into the device by use of currying and support and/or connection members on the outer wall of each elementary element, on an outer wall of the device, therefore the lightweight and/or efficient support and/or connection members,

- facing near by with the reaction fields of the device corresponding to coupling reactions, to metathesis reactions, to Ziegler-Natta catalysts, to transistor, to fuel cell, to storage batteries, to batteries and to so on, plural assemblies in the device are connected with zero or more lead wires. In carefully dealing with the zero or more lead wires connected with external loads and/or current and/or voltage sources in the outside world, a module is made from the elementary elements, the device and/or a plurality of the elementary elements and/or the devices.

On an outer wall of the module

- the lightweight and efficient support and/or connection members are equipped, as well as the support and/or the connection members on the outer walls of the elementary element are lightweight and efficient are equipped with.
- A high-level module which is made of a plurality of modules having many lead wires connecting with zero or more external loads or connectors of current or voltage sources, a plurality of the high-level modules are manufactured into further high-level module..., and then a system is also manufactured by the use of as well as the support and/or connection members on the outer wall of each elementary element are lightweight and efficient are equipped with,

It is desirable that the support and/or connection members on the outer wall of the above mentioned modules are preferably common with the elementary elements, devices and systems.

In the "Background Art", catalytic reaction systems, field effect transistors or other kinds of transistors and so on which are made from electronic parts, a thermoelectric conversion element, fuel cells, batteries, an electron gun and so on have been described, the device or the module corresponding to these illustrate one or more embodiments in accordance with the principles of the present invention, and together with the present specification, are illustrated such an embodiment schematically. The conceptual example of the present invention is in the description that emphasizes an essence of the invention but are not intended to identify the present invention.

The outer wall and the assembly described above are the elementary element, designs of controlling Particle Beams flow limited in the outer wall of the elementary element can be classified as follows.

a. For light mass Particles, such as electron, hole, etc., when a cross-sectional area of the outer wall perpendicular to Particle Beam flow becomes a narrower shape of the outer wall, and the intervals between unoccupied states and occupied states of the allowed energy states for Particle in Particle Beams are wider than the thermal energy of the elementary element, so Particle is less likely to occur transitions between the unoccupied states and the occupied states the due to the thermal energy. As a result, motions of Particles become pseudo-one-dimensional, and Particle are hardly scattered.

b. For heavier mass Particles of Partcle Beams than the electron or the hole and so on, when Particle motion perpendicular to a particle beam flow in an assembly limited by the outer wall is much smaller than that of parallel to the flow, the motion of Particle of Particle Beams becomes quasi-one-directional, and then, a flow amount of Particle Beams becomes maximum.

c. In case that Particle Beams moving along high speed diffusion paths such as diffusion in a nano-material, those moving in parts of columnar layer porous structures, lamella or the like structures, those moving in a polymer electrolyte membrane(PEM) or a cell membrane and the like, and other Particle except Particle Beams which contribute to radiation heat of the elementary element are in such gaseous and/or liquid states including a turbulent flow, Particles of Particle Beams becomes the pseudo-one-dimensional one, and then the flow amount of Particle Beams becomes maximum.

d. Like an electron gun, in Particle Beams of atoms or molecules the other atoms and/or the other molecules except the atoms and/or the molecules in Particle Beams are removed. And kinetic energy distributions perpendicular to Particle Beams flow are very much sharper than the distribution of the thermal energy. That makes the flow amount of Particle Beam maximum.

The assemblies in the above mentioned a ~ d can be designed as follows.

a. The assembly, where Particle Beam flows in an entire internal of nano or more large-size of the elementary element, assumes to be in a crystalline structure.
In the assembly including impurities, disturbances of atoms and/or molecules and disorders existing in an interface of the crystalline structure near-by touching both inner-parts of the outer wall protecting and separating Particle Beams from the external world and so on, and the thermal motion of the assembly make the allowed energy levels of Particles in Particle Beams have complicately wide.

In the assembly disturbed only by the thermal motion, even if the structures of the constituent atoms and/or molecules touching near-by the inner parts for the outer wall of the cross-section perpendicular to direction of Particle Beam flow, are in disorder, the energy states allowed for Particle of Particle Beams flows are completely determined by the quantum mechanics.

The lowest energy level for the assembly of the elementary element having the length $L$ parallel to the pseudo-one-dimensional ballistic conduction and having the cross-sectional area $S$ perpendicular to that determines the value of $S$ at the center of which existence probabilities of Particle are large and at that of which the lowest energy level is less susceptible to influence of disturbance by the disorder of the constituent atoms and/or the molecules at a periphery of the cross-section area.

In case that the intervals between the unoccupied states and the occupied states of the energy levels of Particle in Particle Beams moving in the assembly being in size of $L$ and $S$ is larger than thermal energy of the elementary elements, the energy state of Particle in Particle Beams is better S/N ratio than that of Particle Beams in the assembly that square root of $S$ is grater than nano-order.

At the particle movement portions in the assembly, Particles of Particle Beams interacting each other and with lattice vibrations and so on are in diffusive conductions, but the cross-sectional area becomes narrow so the motion of Particles of Particle Beams is in the pseudo-one-dimensional movement.

In case that the cross-sectional area becomes still more narrower and that attenuation coefficients of Particle moving parallel to the length $L$ are one or more orders of figures shorter than those, Particle Beams may be in the pseudo-one-dimensional ballistic conduction. In the ballistic conduction effects on Particle Beams by impurities which are constituent atoms, molecules and so on in the periphery of the cross-section, are negligible, the S/N ratio is further more improved.

Therefore, an optimal design of nano-order or more the assembly inside which the impurity concentration $c$ exists and in which the pseudo-one-dimensional ballistic conduction for such as hydrogens, electrons, holes, and so on occur is as follows

a-1. Set to shape a certain geometrical form of the assembly.

a-2. Set a type of variety and each mixing ratio of impurity atoms and/or molecules, constituent atoms and/or molecules and vacancies constructing the assembly and all the constituent members, and each position vector $\vec{R}_\tau(t)$ for all the members in the above set geometrical the form of the assembly. Here $\vec{R}_\tau(t)$ is the position vector for the one of all members $i$ - th specie including the impurity and the vacancies in the assembly at a time $t$ except Particle Beams,

$$\{\text{Math. 8}\}$$
$$c(t) =,$$

here $V$ is a geometrical volume of the assembly.

a-3. Applying the quantum mechanics to the assembly described at a-2., and the energy states as functions of $L$ and $S$ are determined.

a-4. Depending on distributions of Particles of Particle Beams due to the heat of the assembly over the energy states derived from described at a-3 times for Particles of Particle Beams, the wave-function of Particle $\Psi$ in the pseudo-one-dimensional system depending on configuration of the constituent impurity atoms and molecules including vacancies, except Particles of Particle Beams is presented as $\exp(-x/\xi(c,T))$ or $\exp(-x/\xi(\bar{c}(t),T))$, which attenuate with the attenuation coefficient $\xi(c, T)$ or $\xi(\bar{c}(t), T)$. Here the absolute value of a conduction variable of Particles of Particle Beams is expressed as $x$. Secondary or more correlation wave-functions of Particles of Particle Beams in the pseudo-one-dimensional systems also depend both on the distributions of Particles of Particle Beams due to the heat of the assembly and are attenuated in the same way as $\Psi$. Attenuation coefficients of those wave-function are $\xi_l^s(c,T)$.

a-5. In order to determine the condition of $L$ and $S$ in a range of the operation temperature of the elementary element, relationships among $\xi(c,T), \xi_l^s(c,T)$ and $L$ satisfy a following condition that is $\xi(c, T)$ and $\xi_l^s(c,T)$ $>> L$ and $\xi_l^s(\bar{c}(t),T) >> L$ in {Math. 3}, and moreover the values of $L$ and $S$ are also determined to fit the assembly in case of the mixing rate $c$ and $T$.

a-6. The mixing ratio for the impurities of the atoms and/or molecules including the vacancies in the assembly in the above mentioned a-2 and the configurations both of the impurities of the atoms and/or molecules including the vacancies except Particles of Particle Beams and of all the support and/or the connection members in the outer wall are changed little by little, at each change the above a-3 to a-5 procedures are carried out in the same way. The optimization for the variety of the atoms and/or molecules and the impurity atoms and/or molecules the including vacancies constituting more nano-order size of the assembly.

a-7. In case that Particles of Particle Beams in the initial geometrical form of the assembly having set in above a-1, are electric and/or magnetic Particles including the effect on Particles of the Particle Beams influenced by a space time variation of electromagnetic fields whose sources are set in the modification portions, not only the values of $L$ and $S$ which may vary along the pseudo-one-dimensional length $L$, but also the geometrical form of the assembly are changed and are made up into the optimal assembly to suppress the influence of S/N ratio.

In the above described b, taking the direction along L as the X-axis direction and from the equilibrium balance between a time depending concentration $C_d$ $(x, t + \tau)$ of diffusive Particles located in the plane perpendicular to $L$ at a position $x$ along the X-axis at a time $t + \tau$ and $C_d$ $(x - X, t)$ located at a position $x - X$ at time $t$, a diffusion equation or a master equation is derived. In case that diffusive Particles are in quasi-ballistic conduction, but the other constituent particles except Particles only move in more movements than the thermal vibration but not in movements of gaseous and/or liquid states, by the use of the time depending concentration $C_d$ $(x, t)$ of the diffusive Particles, the design of optimal nano-order or more geometrical form of the assembly is as follows,

b-1. set the varieties for the constituent Particles, which do not conduct quasi-ballistically in the assembly and which are the impurity atoms and/or molecules including the vacancies, and mixing ratio $c_M(t)$ among each diffusive Particle being in quasi-balistic condition and the net constituent atoms and/or molecules include vacancies except Particles. Here,

{Math. 9}

$$c_M(t) = \left[\sum_{i=1,2,\cdots} \delta(\overrightarrow{R_i^M}(t))\right]\bigg/ V,$$

$\overrightarrow{R_i^M}(t)$ represents a time $t$ dependent spatial position vector of the $i$ - th specie of the diffusive atoms and/or the diffusive molecules and the constituent impurity atoms and/or molecules including the constituent vacancies except Particles. A time variation for values of $\overrightarrow{R_i^M}(t)$ is greater than that above mentioned in the case a.

b-2. Set the values of $L$ and $S$ for the geometrical form of the assembly. Set spatial positions in the geometrical form for all the constituent atoms and/or molecules and so on including the diffusive Particles moving in quasi-one-directional in the assembly.

b-3. Giving attention to a displacement of the diffusion Particle $\overrightarrow{R}$ = $(X, Y, Z)$ limited by $L$ and $S$ of the assembly, since the moving quasi-one-directional direction is parallel to X-axis, paying attention to $X$ component of $\overrightarrow{R}$ a partition function of the diffusion Particles $W(X,\tau)$ is introduced. A concentration $C_d(x, t + \tau)$ for the diffusion Particles located in the plane at $x$ at a time $t + \tau$, some of whose diffusive Particles had located in the plane $X = x$ at a time $t$, so $C_d(x, t + \tau)$ is

{Math. 10}
$$C_d(x, t + \tau) = \sum_X C_d(x - X, t)W(X, \tau)$$

Here, the summation is carried out over all $X$.

b-4. Using the expansions of $C_d(x, t + \tau)$ near-by $\tau = 0$ and $C_d(x - X, t)$ near-by $X = 0$, the changing rate of $C_d(x, t)$ is determined from

{Math. 11}
$$C_d + \tau \frac{\partial C_d}{\partial t} + \cdots = \sum_X \left[C_d - X\frac{\partial C_d}{\partial x} + \frac{X^2}{2!}\frac{\partial^2 C_d}{\partial x^2} - \frac{X^3}{3!}\frac{\partial^3 C_d}{\partial x^3} + \cdots\right] W(X, \tau)$$

Here $C_d$ is abbreviated for simplicity of the expression as

{Math. 12}
$$C_d \equiv C_d(x, t)$$

And $C_d$ is differentiated with respect to time at $t$ and a plane $X = x$.

b-5. In the phenomenological response theory the relation between the flux $J_i$ of the $i$ - $th$ specie Particle and the generalized thermodynamic force $x_i$ causing $J_i$ is represented by Math. 4, an influence of moving the other Particles except Particles upon Particles in Particle Beams causes the effect of the influence for the dispersion motion of Particles in Particle Beams which is expressed by $\langle X^2 \rangle_{ave}$, is, therefore, related to the diffusion coefficient of Particle in Particle Beams.

b-6. The third or more terms in right hand side of the above Math. 11, each of which is the effect for an influence of the particles except Particles in Particle beams upon Particle conduction, and each of which is described by $\langle X^3 \rangle_{ave}$, $\langle X^4 \rangle_{ave}$ or... as a deviation from Gaussian distribution of the particles in the particle beams except Particles in Particle Beam.

b-7. In case that Particles of Particle Beams in the initial geometrical form of the assembly having set in above b-1 are charged or magnetized Particles, including an effect on them by electromagnetic fields on the modification portion varied with space-time, from the initial geometrical shape of the assembly, not only the values of $L$ and $S$ which may vary at time on the place along $L$, but also the geometrical form of the assembly are changed to optimize.

In the above c,

c-a. In the elementary element whose shape of a high speed diffusion path and the like are limited within the outer wall represented by $L$ and $S$, the assembly has a collection of Particle Beams which conduct quasi-one-directionally along the high speed diffusion path $L$ in hollow styloids through the cross-section perpendicular to $L$ circumscribed with in the outer wall but other particles except Particles of Particle beams are in gaseous and/or liquid states by the thermal oscillation.

c-b. In the elementary element in which columnar layer porous structures, lamellar structures and the like in the assembly of $L$ and $S$ keep themselves aligning parallel to $L$, the assembly is made of a collection of pillars or partitions in such a columnar layer, lamellar structures and the like arranged perpendicular to $S$ described in the above c-a. The Particle Beams conduct quasi-one-directionally along $L$ and particles except Particles in Particle Beams, however, are in gaseous and/or liquid states by the thermal oscillation.

c-c. In the elementary elements in which the outer wall of the assembly of $L$ and $S$ is polymer electrolyte membranes (PEM), cell membranes or the like, due to materials of the elementary elements maintaining membrane structure, those keeping Particles of Particle beams conducting quasi-one-directionally along $L$ and the like materials of the elementary elements, the particle beams conducting quasi-one-directonally along $L$ and the other particles, however, except Particles of Particle Beams are in gaseous and/or liquid states by the thermal oscillation.

In the elementary elements described in the above c-a. ~ c-c., a concentration $C_d$ for Particles of Particle Beams, micro-Particles composed of Particles corresponding to such as Particle or molecules chemically bonded with other atoms/molecules are determined by Math. 12. The particles except Particles of Particle Beams, moreover, suppressing their influence on an S/N ratio of Particles Beams in the assembly of $S$ and the quasi-one-direction along $L$ can be estimated by solving by Math. 11, by considering the boundary condition at $L$ and $S$.

In the direction along $L$ in each assembly, conditions for respective Particles in a group of Particles of Particle Beams having a setting up energy $E$, in which the other particles except Particles of Particle Beams suppress their influence on the S/N ratio of Particle Beams maximally conducting along the quasi-one-direction, and those for optimal designs of nano or more orders of each assembly are:

c-1. Due to Particle Beams scattering by the outer wall, the pillars, the partitions, the parts and so on described in the above c-a. ~ c-c., and scattering and interferences among Particle Beams and the particles except Particle Beams and between Particles of Particle Beams, deviations of path for Particles of Particles Beams from a target path along the quasi-one-directional path are estimated.

c-2. The energy spread $\langle \Delta E \rangle = \langle \Delta E_{\perp} \rangle + \langle \Delta E_{\parallel} \rangle$ from the setting up energy $E$ of Particle in a group made of Particle Beams conducting along the quasi-one-directional path and the ratio $\langle \Delta E \rangle / E$ are determined from elastic deformations in an elastic body, from flows using Rheology and from a gaseous and liquid phases including turbulent flows by a gas theory and/or a liquid theory. Here $\langle \Delta E_{\parallel} \rangle$ is an energy spread per Particle parallel to the quasi-one-dimensional direction, $\langle \Delta E_{\perp} \rangle$ is that of perpendicular to the quasi-one-dimensional direction. Here, $\langle A \rangle$ is an average for the physical quantity $A$ over a distribution of all the particles in assembly affected by the outer wall.

c-3. Because $\langle \Delta E_{\parallel} \rangle / E$ and $\langle \Delta E_{\perp} \rangle / E$ increase when $E$ is small, if Particles of Particle Beams have electric and/or magnetic charges, including influences on Particles of Particle Beams due to space-time depending electromagnetic fields set on the modification portions, not only $S$ changes depending on time and/or on the location of $L$ enclosing the position of all the Particle of Particle Beams, but also the form of the assembly are changed optimally in order to minimize their influences on S/N ratios of $\langle \Delta E_{\parallel} \rangle / E$ and $\langle \Delta E_{\perp} \rangle / E$.

In the above d., the dispersion motion of Particle Beams is only determined by the concentration $C_d$ in Math. 11. Optimal design of the assembly having nano or more order $L$ and space-time variations of $S$ at the location of $L$ is:

d-1. Interactions among Particles of Particle Beams whose each Particle energy is initially the setting up energy $E$ and those between Particles of Particle Beams and the outer wall,

d-2. If Particles of Particle Beams have electric and/or magnetic charges, Particles of Particle Beams vibrate around their equilibrium orbits through the space-time-changing $S$ and/or an electromagnetic field in the modification portions,

d-3. In the same manner as described in the above c-2, the ratio of $\langle \Delta E \rangle = \langle \Delta E_{\perp} \rangle + \langle \Delta E_{\parallel} \rangle$ to $E$, that is $\langle \Delta E \rangle / E$ in the assembly including the macroscopic quantum system is determined by using quantum mechanics, classical mechanics, the thermodynamics, statistical mechanics and so on,

d-4. In the same manner as described in the above c-3, the smaller $E$ is, the more $\langle \Delta E_{\parallel} \rangle / E$ and $\langle \Delta E_{\perp} \rangle / E$ increase. Here $\langle A \rangle$ represents the average of physical quantity $A$ on Particles of Particle Beams in the assembly influenced by the outer wall.

d-5. The variation for the distribution of the electric and/or the magnetic and/or neutral charged particles in the assembly including the form of the assembly depending on time-space is optimized to suppress their influences on S/N ratio of $\langle \Delta E_{\parallel} \rangle / E$ and $\langle \Delta E_{\perp} \rangle / E$

In general, the assemblies can not be distinctly categorized in the above a ~ c. Moreover the above optimized design of nano or more order assemblies in such as a ~ c as well as d are merely examples, the above optimized design is changed together with developing computer simulation and is not intended to be fixed.

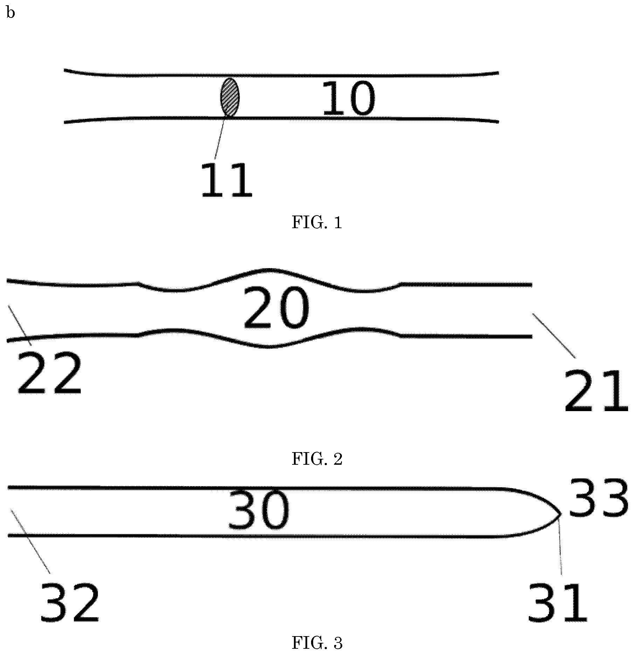

As to Particles of Particle Beams which are in through the assembly 10 and/or from the emission source end to the absorption source end of the outer wall in Fig. 1, since the assembly, whose small cross-section 11, is equipped with, claim 1 makes practically Particles of Particle Beams which have less susceptible to influence on the S/N ratio due to disorders for a stereo structural lattice or composition of constituent materials and/or the heat of the elementary element, be emitted from the emitting source end or absorbed from the absorption source ends, released to other assemblies and/or reaction fields, or absorbed Particles in good order from other groups of Particle Beams.

In illustration of the elementary element making less susceptible to the influence on the S/N ratio in accordance with principle of the present invention, the accompanying drawing, in which it is omitted to illustrate the outer wall, the emission source and/or the absorption source ends, the modification portions, electromagnetic sources, mechanical parts and the like in the outer wall, the support and/or the connecting members in the outer wall and/or associated with other of the elementary elements or other parts, the reaction fields and the like, and in which the elementary element is watched mainly illustrated only the assembly, together with this specification, is intended to briefly, clearly and schematically explaining such one or more embodiments which construct this specification. Although the following conceptual diagrams of the present invention emphatically explains principles of the present invention, of course it is not intended to identify the present invention.

In turn, such as an apatite type lanthanum silicon oxide, structures of the high-speed-diffusion-path or columnar-layer-porous, which are atoms, ions and/or molecules can move only through a hollow styloid structure direction in the assemblies made of spatial constructions having the hollow styloid structures. It is possible that interactions between the materials constituting the assembly and Particles of Particle Beams make Particle Beams a selective flow. As illustrated in Fig.2, the particles of the material constituting the assembly in the modification portions may alter the thickness of the assembly and/or compositions of the constituent atoms and/or molecules, thereby it is possible to alter kinds of Particles moving in the assembly and/or to adjust thier amount of flows.

The form of the quasi-one-dimensional assembly 30 varies with the kind of Particles of Particle Beams. As described in the above a., for electrons and/or holes the degree of each thermal noise depends on disorders around the cross-section of the assembly and the temperature of the elementary element.

The smaller the square root of the cross-section area $S$ becomes, even if the temperature of the elementary element is the room temperature, the less transitions from the highest states of the electrons and/or the holes to the respective lowest states due to the thermal noise dose occur, moreover, if the electrons and/or the holes are in the macroscopic quantum states, the S/N ratio of the elementary element is further improved.

As described in the above b., for Particles being atoms, ions, and/or molecules, interaction forces among Particles of Particle Beams in the assembly 30 made of spatial constructions having the hollow styloid structures, and/or among Particles of Particle Beams, the particles except Particle Beams in the assembly 30, the particles of the outer wall, the particles of the modification portions and Particles of Particle Beams through other the elementary elements and so on make the S/N ratio of its own the elementary element improve.

As described in the above c., in case that the diameter of the hollow styloid structures is large, the flow in the hollow syloid structures is also controlled by taking account of laminar including turbulent flows. As a result energy consumptions of the cooling maintenance for the device can be reduced. In case that Particles of Particle Beams are charged particles, through a protuberance 31 built on the emission source end and/or the absorption source end, the electric fields near-by charges on the electrode facing with it or the emission source end and/or near-by the absorption source end facing with 33 due to target charges enlarge, moreover those bring a result on Particles of Particle Beams being easy to be emitted and/or absorbed.

When a temperature difference between the particle movement portion and the emission source or absorption source end is large, for example

1. by means of making the surroundings of the outer wall including the parts and so on except the assembly 30 vacuum or the like, the heat hardly transmitting outside through the structures of the elementary element except the radiation loss, the heat conduction from the emission source end to the absorption source end is suppressed except the thermal energy of the charged particles,

2. by making use of the thermoelectric materials or the thermoelectric conversion elements in the assembly 30 in which the flows for Particles of Particle Beams and/or Particle Beams occur in the elementary elements having the emission source and/or the absorption source, the effect of NEA or PEA of the plural the elementary elements is increased,

3. and the catalytic effects and the like of the elementary element having the emission source end and/or the absorption source end increase.

A particle changes its momenta but it is difficult to alter its energies in case of colliding with large mass than it. A concrete example of claim 2 characterizes that the low-energy Particles of Particle Beams, which are in the better against the depreciation of S/N ratio due to disorder of the stereo structures and lattices of the constituent materials and the heat of the elementary element, are strongly oozed out to a localized and nano-order absorption end 41, so that the low-kinetic-energy Particles of Particle Beams interact at the area 43 with a shooting particle 45 emitted from a shooting particle emitting source 44. The low-kinetic-energy Particle being in good S/N ratio prepared from the elementary element combines with the shooting particle 45 being the large mass than that of the low-kinetic-energy Particle to produce an energy state of a cojioning shooting particle in good S/N ratio.

Or a charge transfer occurs, and the flows of charge transferred shooting particle and/or particle beams are produced to be in good S/N ratio. Using the low-kinetic-energy Particles in good S/N ratio of the elementary element as electrons, charges of the shooting charged massive particles in good S/N ratio are neutralized, so that the neutral charge massive cojioning shooting particles in good S/N ratio are able to be obtained even in low-kinetic energy. On the other hand, for the the neutral charged massive conjioning shooting particles with the high energy, because the thermal energy is negligible to the high energy, they are always in good S/N ratio.

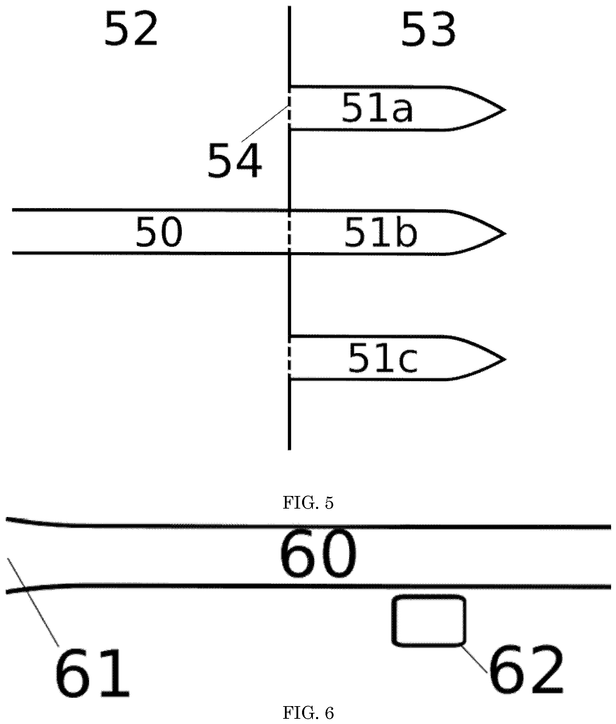

Using atoms, ions and/or molecules as Particles of Particle Beams, electrons, holes, atoms, ions, and molecules can be reacted with them after the leaving point or before the starting point of the particle movement portion in the elementary element. Claim 3 is possible to control reactions by control of Particle Beams passing through the assembly. In Fig. 5 in which a plurality of the elementary elements taken a spatial arrangement in a device, kinds of Particle Beams moving through the assembly of each elementary element in 50 and 51 may be also varied each other. In each assembly have the hollow styloids through which ions transmit and contacting with holes and the like in the membrane 54, and so on. That makes various kind of the particle beams selectively move through the assemblies. 52 and 53 are indicated in that each material may be differ each other, the membrane 54 makes Particle Beams selectively pass through.

Though the above described device can be applied to porous support layers of polymer electrolyte membranes (PEM) + anode catalyst layers, in order to completely understand various aspects of models being connected with the claims in the above description in Fig.5 , it is necessary that by way of various examples form deformations of end surfaces at the emission source end and/or the absorption source end, deformations and/or the temperature change of the reaction field, amplitude variations of electromagnetic fileds acting on the reaction fields, coatings and/or materials on the emission surface end and/or the absorption surface end contacted with the reaction fields, actuators of mechanical plates for control of reacting and/or produced materials in the reaction fields, compound structures consisted from the elementary elements, modules and devices, and systems designed in consideration of external loads and the like are taken into account, and, moreover, an optimization for systems and the like designed in consideration of the radiant heat, protections, and the like of the elementary elements, the devices, modules including upper classes of modules, and the systems and the like are described. However, such specific descriptions are intended to be presented for that of each individual circumstance, and should not be limited the present invention according to the claims including claims described below.

Claim 4 is able to allow that through an assemblage of the elementary elements the assemblage of the elementary elements modifies their respective original functions of the elementary elements and/or has other functions from their functions of the elementary elements. A pair for the assembly of an elementary element and the assembly of another one dose not need to be combined with one-to-one, it is also possible that some assembly of the elementary elements are combined with the assemblies for a plurality of other elementary elements in multi correspondence. Moreover, since kinds of Particle Beams moving through the each assemble may change on its way, an assembly of an elementary element is need not to correspond to an assembly of another elementary element in one-to-one correspondence.

Claim 5 characterizes that, in Particles of Particle Beams moving through the particle movement portion 60 in Fig 6., electromagnetic fields generation parts 62 placed near-by spatially small place near-by the modification portions on the way to the emission source end or the absorption source end 61 may control physical and/or chemical properties for Particles of the Particle Beams. Using an electric field generation source for 62, it is possible to control the voltage-current characteristics of charged particle beams. Using a magnetic field generation source for 62, in case that magnetic atoms are added to Particle Beam flow part of the assembly, and that spins of these magnetic atoms align in the magnetic field, it is possible to increase a quantum efficiency by improving the spin polarization ratio of Particles of Particle Beams. And it is also possible to control diffusion flows of the Particles or Particle spins of the Particle Beams by concentration gradient field generated in the degree of a few square nano meter for cross-sectional area of a thin wire connecting with an emission source end of an elementary element and an absorption source end of another elementary element.

The emission source end and/or the absorption source end 31 is stained with and/or deformed by charged particles and the like use. By arranging source heating parts in 33 near-by 31, it is possible to reduce the absorption of atoms and molecules, and the deformations by using the emission source end and/or the absorption source end 31.

In case of the emission source and/or the absorption source acting as the source of Particle Beams with good S/N ratio, in claim 6 it is possible to create a device requiring no parts except controlling parts of Particle Beams and having both higher responsiveness and better S/N ratio than the conventional elements. And by lowering an energy consumption for cooling the device, it is possible to improve an efficiency of a system combining modules incorporating series or parallel, or their complex array of the devices with a load in the external world by connection wires. As such devices, a photoelectric surface, a thermoelectric device, a transistor, a diode, a cold cathode tube, a fuel cell and so on are considered. In addition it may be considered to incorporate the devices into the module and/or the system.

The cases that a device is made from series, parallel, or complex hybrids of series and parallel of the elementary elements as described in claim 6. that a device dose them of the elementary elements which are removed the controlling part of Particle Beam in the elementary element or that the devices are made of the elementary elements with or without the controlling part of Particle Beams in claim 6 and the conventional elements except claim 6 are considered.

Obviously, a module being combination of those devices, devices and other the elementary elements is also constructed in accordance of the scope and spirit of the present invention. Therefore a system is able to be made of the low-energy particle emission sources and/or absorption sources having less influence on an S/N ratio than systems including modules according to only the conventional elementary elements. Obviously, to provide a method for implementing devices constructed from the elementary elements, modules, and systems, may be employed in numerous embodiments.

Claim 7 makes it possible to store an energy by absorbing particles in a particle reservoir by using the elementary element connecting with the particle reservoirs, or utilize the energy of the particles by releasing the particles from the particle reservoirs through the connected elementary element connecting with the particle reservoirs. For elementary elements used here are in a good S/N ratio, so the energy efficiency of the above system is much higher.

Any actuators, modules, and systems in the description of the present application, unless warning is especially noted, are not to be considered as importantly or decisively essential for the present invention.

{Advantageous Effect of Invention}

The present invention can reduce an influence of the S/N ratio due to the heat of the elementary element by decreasing the cross-sectional area of the emission source end or the absorption source end. Because that emitting electron flows can be controlled by bias currents if an area of the emitting source end is very small and the emitting source ends for a large number of the elementary elements can be closely arranged each other, then a reduction in energy consumption required to operate a cooling a system at low temperatures can occur much more significantly than that for the negative voltage control electrode, and the system is also able to have the quick responsibility. Furthermore, by adding magnetic atoms or molecules in quasi-one-dimensional system in the assembly, high-spin-polarization having less depolarization of electron spin by an external magnetic field and a high quantum efficiency are obtained.

{Industrial Applicability}

A double quantum dots used in quantum computer is in having a stable charge state that an excess electron tunnels between two quantum dots (Phys. Rev. Lett. 91,226804-2(2003)). The double quantum dots can be controlled by applying a drain pulse to a device of the ementary element. By doing this quickly, the quick responsibility of the elementary element can be provided.

{Brief Description of Drawings}

{Fig. 1} An assembly connecting with an emission source or an absorption source of the elementary element.

{Fig. 2} An assembly connecting with an emission source end or an absorption source end of the elementary element.

{Fig. 3} An elementary element having an emission source end or an absorption source end.

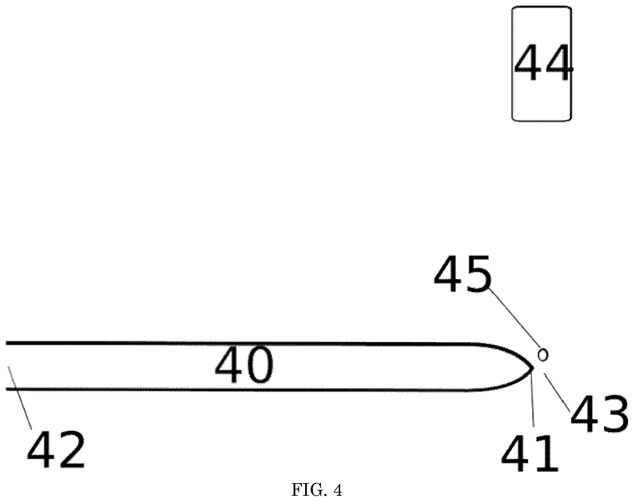

{Fig. 4} An elementary element having an emission source end or an absorption source end with shooting particle source.

{Fig. 5} An elementary element having emission source end or absorption source ends.

{Fig. 6} An emission source end or an absorption source end with a control part.

{Reference Signs List}

10 An assembly in a particle movement portion for Particles of Particle Beams

11 A cross-section of an assembly

20 An assembly in a particle movement portion for Particles of Particle Beams

21 An emission source end for Particle of Particle Beams

22 An absorption source end for Particles of Particle Beams

30 An assembly in a particle movement portion for Particles of Particle Beams

31 An emission or an absorption source end for Particle of Particle Beams

32 An absorption or an emission source for Particle of Particle Beams

33 A reaction field near-by an emission or an absorption source end for Particles of Particle Beams

40 An assembly in a particle movement portion for Particles of Particle Beams

41 An emission source or an absorption source end for Particle of Particle Beams

42 An absorption source or an emission source end for Particle of Particle Beams

43 A reaction field near-by an emission source or an absorption source end for Particles of Particle Beams

44 An emission source for a shooting particle

45 A shooting particle

50 An assembly in a particle movement portion for Particles of Particle Beams

51a, 51b, 51c Assemblies in particle movement portion for Particles of Particle Beams

52, 53 Particle spices parts

54 A boundary among assemblies and spices parts

60 An assembly in a particle movement portion for Particles of Particle Beams

61 A control part

**Claims**

1. An elementary element characterized as follows:

   for a particle motion perpendicular to a direction of the particle beams in the elementary element (hereafter, the elementary element is represented as Elementary Element),
   the particle energy intervals between unoccupied states and occupied states of the particle of the particle beams are so wider than the thermal energy of Elementary Element that cross-sectional areas through which the particles of the particle beams almost perpendicularly move are narrow;
   because that in Elementary Element having a particle emission source end and a particle absorption source has a length exists from the particle emission source end and/or a particle movement portion to the particle absorption source end,
   influences of S/N ratio due to disorder of stereo structures and lattices of constituent materials for Elementary Element and/or the thermal energy of Elementary Element restrained down, moreover,
   the particles under the restrained influences of S/N ratio are transmitted to utilization ports of the particles, as just the influences are, those constitute a characteristic feature of Elementary Element having the particle emission source and/or the particle absorption source.

2. The elementary element according to claim 1, further comprising:

   from an elementary element emitting neutral charged particle beams, the neutral electric charged particles of the neutral electric charged particle beams,
   which are made from uniting electric charged particle beams emitted in low-kinetic-energy with good S/N ratio from the emission source of the elementary element described in claim 1 with the different polarity for the electric charged particles of particle beams controlled in the low-kinetic-energy from a conventional element or another elementary element,
   are in less influences of S/N ratio due to thermal energies of the conventional element or others and the other elementary element in higher temperatures than the above elementary element.

3. The elementary element according to claim 1, further more comprising:

   an elementary element, whose particles of the particle beams through the modification portions interact with the emitted particles of the particle beams having good S/N ratio from the emission source of the elementary element described in claim 1,
   or which absorbs the emitted particles of the particle beams having good S/N ratio at an absorption source of the elementary element,
   generates completely almost same direction of motion and almost same value of motion energy for the particles of the particle beams, and/or almost same heat and/or electricity per the particle.

4. A device according to claim 3, further comprising:

   in the device made from the elementary elements according to claim 1, claim 2 and claim 3
   it is possible, if necessary, that
   kinds of the particles of the particle beams, which move in some particle movement portions of the device, statically or dynamically change on the way of their respective particle movement portion of the device ,
   or functions of each constituting elementary element of the device are enhanced more than those of it,
   or original functions of each constituting elementary element of the device are modified to other functions of it.

5. An emission and/or an absorption source elementary element comprising:

   in an emission source and/or an absorption source of the emission source and/or the absorption source element made from the elementary element according to claim 1, claim 2 and claim 3 and claim 4

the emission source and/or the absorption source element has parts, which are attached on the particle movement portion to the emission source end,

are able to control a degree of freedom for particles of the particle beams emitted from the emission source and/or the absorption source element

and to regulate an amount of particle flow of the emission source and/or the absorption source element,

or, if necessary, other parts, which are heaters.

6. A device comprising:

   the elementary elements according to claim 1, claim 2 and claim 3 and claim4.

7. A storing and/or releasing energy device comprising:

   in the storing and/or releasing energy device whose emission or absorption sources described in claim 1, claim 4 and claim 5 are connected with one or more particle reservoirs,

   by controlling external conditions of the storing and/or releasing energy device and the particle reservoirs,

   in the cause that particles of the particle beams of the storing and/or releasing energy device are exchange at very least between two particle reservoirs or among more particle reservoirs,

   the storing and/or releasing energy devices function efficiently as a storing and/or releasing energy.

b

FIG. 1

FIG. 2

FIG. 3

44

45

40

42

41

43

FIG. 4

EP 3 121 146 A1

52    53

51a

54

50    51b

51c

FIG. 5

60

61    62

FIG. 6

23

**INTERNATIONAL SEARCH REPORT**

| International application No. |
| --- |
| PCT/JP2014/059380 |

A. CLASSIFICATION OF SUBJECT MATTER
*B82B1/00*(2006.01)i, *B82Y30/00*(2011.01)i, *H01J1/304*(2006.01)i, *H01L29/66*
(2006.01)i

According to International Patent Classification (IPC) or to both national classification and IPC

B. FIELDS SEARCHED

Minimum documentation searched (classification system followed by classification symbols)
H01J1/304

Documentation searched other than minimum documentation to the extent that such documents are included in the fields searched

| | | | |
| --- | --- | --- | --- |
| Jitsuyo Shinan Koho | 1922–1996 | Jitsuyo Shinan Toroku Koho | 1996–2014 |
| Kokai Jitsuyo Shinan Koho | 1971–2014 | Toroku Jitsuyo Shinan Koho | 1994–2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X | JP 2007-149659 A (Sumitomo Electric Industries, Ltd.), 14 June 2007 (14.06.2007), entire text; all drawings (Family: none) | 1 |
| E,X | JP 2014-046451 A (Mahito MABUCHI), 17 March 2014 (17.03.2014), entire text; all drawings (Family: none) | 1 |

☐ Further documents are listed in the continuation of Box C.  ☐ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 04 September, 2014 (04.09.14) | 16 September, 2014 (16.09.14) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

## INTERNATIONAL SEARCH REPORT

| International application No. |
|---|
| PCT/JP2014/059380 |

**Box No. II    Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☒ Claims Nos.: 2-7
   because they relate to parts of the international application that do not comply with the prescribed requirements to such an extent that no meaningful international search can be carried out, specifically:
   There is no disclosure of specific embodiments in the description, and thus the specific configuration of a basic element, device, or system in the inventions in claims 2-7 and a technical field to which the basic element is applicable cannot be grasped.

3. ☐ Claims Nos.:
   because they are dependent claims and are not drafted in accordance with the second and third sentences of Rule 6.4(a).

**Box No. III    Observations where unity of invention is lacking (Continuation of item 3 of first sheet)**

This International Searching Authority found multiple inventions in this international application, as follows:

1. ☐ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**        ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

## REFERENCES CITED IN THE DESCRIPTION

### Patent documents cited in the description

- JP 2011058856 A
- JP 2011057202 A
- JP 2012071529 W
- JP 2012104768 A
- JP H5190296 B

### Non-patent literature cited in the description

- **AKIRA HONMA ; AKIKO SAWAMURA ; HATSUO YAMAZAKI ; KATSUHIDE NAKATA ; KOUMEI TANIDA ; SADAFUMI SAWAMURA ; KUNIHIKO TSUMORI.** Design of linear accelerator for low emittance electron gun. *Hokkaido University Faculty Engineering Department Research Report,* 1995, 57-63
- **YOSHIAKI MAKINO ; RYO IIYOSHI.** Electric field analysis of Schottky cathode by surface charge method. *Aichi industrial University research report,* 2006, 33-40
- **B. JEAN-MARC et al.** *Phys. Rev. Lett.,* 2002, vol. 89, 17962-1, 19769-4
- **P.W.ANDERSON.** *Phys. Rev.,* 1958, vol. 109, 1492
- **MABUCHI et al.** *Niihama National College of Technology Bulletin,* 2002, vol. 35, 29-40
- *Journal of Television,* 1978, vol. 32 (8), 670
- **M. KUWAHARA.** development of high brightness spin polarized electron source. *Japan accelerator Society Annual Meeting 2,* 2005, 105
- **S. KOBAYASHI et al.** Remarkable Effect of Bimetallic Nanocluster Catalysts for Aerobic Oxidation of Alcohols: Combining Metals Change the Activities and the Reaction Pathways to Aldehydes / Carboxylic Acids or Esters. *Journal of the American Chemical Society,* 2012, vol. 134, 16963
- **T. KUDO ; H. OBAYASHI.** *J. Electrochem. Soc.,* 1976, vol. 123, 415
- **MAHITO MABUCHI ; DAISUKE HIGASHIURA ; KENJI MORITA ; JUN MANABE ; KATSUHITO OKADA.** *Niihama National college of Technology,* 2006, vol. 42, 17-23
- **KOUJI ONISHI ; HIROMASA MORITA ; DAISUKE HIGASHIURA ; MAHITO MABUCHI.** *Niihama National College of Technology,* 2006, vol. 42, 25-34
- **KIYOSHI KOBAYASHI.** Elucidation of reverse Frenkel defect equilibrium in apatite type lanthanum silicon oxide. *Scientific Research Grant Program Research Report,* 22 June 2012
- **H. MAILER ; TATSUICHIRO FUJIWARA.** Diffusion in Solid. Maruzen publish, 2007
- *J. Plasma Fusion Res.,* 2009, vol. 85 (4), 199
- *Phys. Rev. Lett.,* 2003, vol. 91, 226804-2